# EUROPÄISCHE PATENTSCHRIFT

(11) **EP 1 670 302 B1**
(45) Veröffentlichungstag und Bekanntmachung des Hinweises auf die Patenterteilung: **18.03.2009**
(21) Anmeldenummer: 05020692.9
(22) Anmeldetag: 22.09.2005
(51) Int. Cl.: H05K 7/18

(54) **Rahmengestell**
Frame
Armature

(30) Priorität: 09.12.2004 DE 102004059408
(43) Veröffentlichungstag der Anmeldung: 14.06.2006
(73) Patentinhaber: Knürr AG, 94424 Arnstorf (DE)
(72) Erfinder: Bumeder, Gerhard, 84164 Moosthenning (DE); Knab, Josef, 94439 Rossbach (DE); Schneiderbauer, Siegfried, 94439 Rossbach (DE); Prinz, Alexander, 84389 Postmünster (DE); Spateneder, Werner, 84347 Pfarrkirchen (DE)
(74) Vertreter: Heim, Hans-Karl

(56) Entgegenhaltungen:
- EP-A- 1 064 795
- DE-A1- 3 930 133
- US-A1- 2002 104 942

## Beschreibung

Die Erfindung betrifft ein Rahmengestell gemäß dem Oberbegriff des Anspruchs 1.

Die Erfindung ist insbesondere für Geräteschränke geeignet, welche zur Errichtung lokaler Netze eingesetzt werden und zur Aufnahme elektrischer, elektronischer und optoelektronischer Geräte, Bauteile und Komponenten und relativ großer Kabelmengen sowie von Kabeln mit unterschiedlich großen Durchmessern ausgebildet sind.

Bekannte Rahmengestelle für Geräteschränke weisen einen oberen und unteren horizontalen Rahmen aus jeweils zwei Tiefen- und Querholmen auf. Die Rahmen werden in Eckbereichen durch vier Vertikalholme miteinander verbunden und dadurch ein Aufnahmeraum für Geräte, Bauteile und Kabel gebildet. An dem Rahmengestell können Verkleidungsteile, z.B. eine Fronttür, Seitenwände, eine Rückwand, eine Abdeckung und ein Bodenblech angebracht werden, um einen allseitig geschlossenen Geräteschrank auszubilden.

Für Anwendungen mit großen Kabelmengen und für Kabel mit relativ großen Durchmessern und geringer Biegbarkeit sind Rahmengestelle erforderlich, welche einen freien Zugang für die Kabel in den Aufnahmeraum und eine ungehinderte Verkabelung und Kabelführung mit einem möglichst allseitigen Zugriff zu den Verkabelungsbereichen ermöglichen.

Aus DE 94 05 618.8 ist ein Rahmengestell mit vier Vertikalprofilen oder zwei seitlichen Tragwänden bekannt, welche eine obere Deckplatte und eine untere Sockelplatte verbinden. Die Deckplatte und Sockelplatte weisen Befestigungsbohrungen auf und sind mit zwei vorderen und hinteren, miteinander fluchtenden Auslegern versehen, durch welche eine vordere und hintere Aussparung für Kabelbäume gebildet wird. Eine Kabelmontage kann an dem relativ offenen, mit den Komponenten bestückten Rahmengestell erfolgen.

In WO 99/48305 A1 ist ein Rahmengestell für einen Telekommunikations- und Netzwerkschrank beschrieben, bei welchem ein oberer und ein unterer horizontaler, rechteckiger Rahmen durch zwei Vertikalprofile verbunden sind. Der Einbau der Baugruppen, Geräte, Kabelblöcke usw. erfolgt an vertikalen vorderen und hinteren Montageholmen, welche Befestigungslöcher des entsprechenden Standards aufweisen und an zusätzlichen unteren und oberen horizontalen Querprofilen befestigt werden.

Aus GB 2 345 240 B ist ein Rahmengestell für einen Geräteschrank mit zwei oder vier Vertikalholmen bekannt, welche oben und unten durch jeweils zwei Querholme verbunden werden. Die zwei Querholme sind U-förmig ausgebildet und im Bereich ihrer Querstege miteinander verbunden oder bilden ein längliches, mittig verbundenes Kreuz.

Aus DE 43 33 947 A ist noch ein Rahmengestell bekannt.

Die bekannten Rahmengestelle, welche relativ aufwändig herzustellen sind, genügen nicht in jedem Fall den Anforderungen an eine ungehinderte Verkabelung und vertikale und horizontale Kabelführung mit freiem Zugriff zu den Verkabelungsbereichen, insbesondere bei Schrankreihen mit seitlich aneinandergrenzenden Schränken.

Der Erfindung liegt die **Aufgabe** zugrunde, ein Rahmengestell für Geräteschränke, insbesondere der Netzwerk- und Telekommunikationstechnik sowie für Schrankreihen, zu schaffen, welches bei einer kostengünstigen Herstellung und Montage eine ungehinderte Verlegung relativ großer Kabelmengen und unterschiedlicher Biegbarkeit sowie eine vertikale und horizontale Kabelführung ohne Einfädeln gewährleistet.

Erfindungsgemäß wird die Aufgabe durch die Merkmale des Anspruchs 1 gelöst. Zweckmäßige und vorteilhafte Ausgestaltungen sind in den Unteransprüchen und in den Zeichnungen beschrieben.

Ein Grundgedanke der Erfindung kann darin gesehen werden, eine selbst tragende Konstruktion eines Grundrahmens zu schaffen, bei welchem vier Tiefenholme, zwei Vertikalholme und zwei Querholme derart angeordnet und verbunden werden, dass ein außerordentlich stabiler und gleichzeitig zerlegbarer Grundrahmen entsteht, welcher eine ungehinderte Verkabelung einer großen Anzahl von Kabeln sowie eine Kabelführung in vertikaler und horizontaler Richtung und insbesondere von einem Schrank zu einem angrenzenden Schrank mit einem freien Zugriff zu Verkabelungsbereichen von allen Seiten gewährleistet.

Erfindungsgemäß wird ein rechter und linker Vertikalholm jeweils am oberen und unteren Ende mit einem oberen und unteren Tiefenholm verbunden, so dass ein rechter und linker Doppel-T-Rahmen gebildet ist.

Bevorzugt erfolgt die Verbindung der Vertikalholme mit dem oberen und unteren Tiefenholm durch Verschweißen, und die derart gebildete Einheit ist vorteilhaft für die Lagerung, den Transport und die Montage des Rahmengestells.

Der rechte und linke Doppel-T-Rahmen wird erfindungsgemäß im Verbindungsbereich der Vertikalholme und Tiefenholme unter Ausbildung einer front- und rückseitigen Rahmenausnehmung durch einen oberen und unteren Querholm verbunden, wobei eine lösbare Verbindung, beispielsweise eine Schraubverbindung, für eine zerlegbare und beispielsweise als flat-Pack lieferbare Konstruktion vorteilhaft ist.

In Draufsicht kann das erfindungsgemäße Rahmengestell auch als H-Rahmen angesehen werden, bei welchem die Tiefenholme die vertikalen Stege und die Querholme den horizontalen Steg bilden.

Auch der rechte und linke Doppel-T-Rahmen kann nach einer 90°-Drehung als H-Rahmen angesehen werden, insbesondere, wenn der Vertikalholm jeweils mittig mit dem oberen und unteren Tiefenholm verbunden wird und somit als ein Mittelholm angeordnet ist.

Indem die bei bekannten Schrankkonstruktionen jeweils in Eckbereichen angeordneten Vertikalholme entfallen und front- und rückseitige Rahmenausnehmungen ohne störende front- und rückseitige Querholme gebildet sind, ist eine ungehinderte Verkabelung und vertikale Kabelführung von oben bzw. von unten sowie horizontale Kabelführung von links und/oder rechts sowie von einem Schrank zu einem angrenzenden Schrank, beispielsweise bei Schrankreihen, gewährleistet. Eine Einfädelung von Kabeln, welche aufwändig und insbesondere bei Kabeln mit entsprechendem Durchmesser schwierig zu handhaben ist, wird vermieden.

Außerdem ist ein ungehinderter Zugriff zu Verkabelungsbereichen von im Wesentlichen allen Seiten, insbesondere von vorn und von der Seite her möglich.

Die erforderliche Stabilität des erfindungsgemäßen Rahmengestells wird durch mehrfach abgekantete bzw. abgebogene Vertikalholme und als C- und/oder U-Träger ausgebildete Tiefen- und Querholme erreicht.

Besonders vorteilhaft können offene Mehrkammerprofile als Vertikalholme eingesetzt werden, welche eine rechteckige Kontur mit relativ schmalen Kurzseiten und etwa zwei- bis viermal längeren Längsseiten aufweisen. Durch Mehrfachabkantungen oder -abbiegungen gebildete, offene Mehrkammerprofile, beispielsweise Dreikammerprofile, können zweckmäßigerweise aus einem Stahlblechzuschnitt im Rollformverfahren oder auch im Biegeverfahren hergestellt werden und können neben ihrer tragenden Funktion noch zur Kabelführung und/oder Befestigung von Kabelmanagement-Komponenten, beispielsweise von Kabelwannen und dergleichen, dienen. Außerdem bieten die in Richtung eines Aufnahmeraumes mit wenigstens einer Mittenöffnung und einem frontseitigen und rückseitigen Innenschenkel versehenen Vertikalholme Anbindungspunkte für Profilschienen und Zubehör, beispielsweise 19" Zubehör, wie Dosenleisten und dergleichen.

In den frontseitigen und rückseitigen Innenschenkeln, welche mit einer Mittenöffnung eine Innenseite der Vertikalholme bilden, können zweckmäßigerweise Befestigungsöffnungen rasterartig und dem jeweiligen Standard entsprechend ausgebildet sein. In einem oberen und unteren Bereich sind außerdem zweckmäßigerweise Löcher für Schraubverbindungen vorgesehen, welche der lösbaren Verbindung mit den Querholmen dienen.

Weitere Befestigungsöffnungen können vorteilhafterweise auch in den schmalen Kurzseiten der Vertikalprofile ausgebildet werden, um Zubehör, Montageholme, Geräte, Baugruppen und Kabelmanagement-Komponenten befestigen zu können.

Eine Kabelführung bzw. Aufnahme von Kabeln ist des Weiteren im Bereich der äußeren Längsseite der Vertikalholme möglich, wobei die Kabel über eine frontseitige und rückseitige Längsöffnung eingeführt werden können.

Zur vorzugsweise festen Verbindung eines Vertikalholms mit einem oberen und unteren Tiefenholm werden Endbereiche der Vertikalholme in eine entsprechende Ausnehmung des jeweiligen Tiefenholms formschlüssig aufgenommen und insbesondere verschweißt. Vorteilhaft ist die Verbindung mit Tiefenholmen mit einem C-förmigen Profil und einer Ausnehmung, welche in einem innenseitig angeordneten Horizontalschenkel und einem oberen und unteren Innenschenkel ausgebildet ist, so dass ein Tiefenholm mit seinem außenseitigen Endbereich an einem vertikalen C-Schenkel und stirnseitig an einem außenseitig angeordneten Horizontalschenkel anliegt. Vorteilhaft erfolgt eine weitere Verbindung im Bereich des oberen und unteren Innenschenkels der Tiefenholme.

Es ist zweckmäßig, wenn die Tiefenholme mit Anbindungspunkten für eine Scharnierung, insbesondere für eine Stiftscharnierung, sowie für eine Verschlusseinrichtung, beispielsweise einen Verschlusshaken, eines als Tür angeordneten Verkleidungsteils versehen sind. Diese Anbindungspunkte sind bevorzugt frontseitig und endseitig vorgesehen und können beispielsweise an den außenseitigen Horizontalschenkeln als Winkel mit entsprechenden Öffnungen ausgebildet sein.

Es ist von Vorteil, dass auch die Tiefenholme aus einem Stahlblechzuschnitt durch Mehrfachabbiegungen und Ausstanzungen hergestellt werden können. Die in die Tiefenholme integrierten Anbindungspunkte können weiterhin einer lösbaren Befestigung einer Rückwand sowie von Seitenwänden und einer Abdeckung sowie eines Bodenblechs dienen.

Zweckmäßigerweise werden als Querholme U- oder C-förmige Träger eingesetzt, welche wie die Tiefenholme mit ihrer Öffnung zueinander gerichtet angeordnet werden. Beispielsweise kann die Breite der Querholme der Tiefe der Vertikalholme entsprechen. Eine vorteilhafte, lösbare Befestigung der Querholme erfolgt an den Tiefenholmen, wodurch die Zerlegbarkeit der Rahmenkonstruktion in zwei Doppel-T-Rahmen und die zwei Querholme und eine Lieferung als Flat-Pack gewährleistet sind.

Zur vorteilhaften Schraubbefestigung weisen die Querholme stirnseitig jeweils eine Befestigungsplatte auf, welche wesentlich höher als die vertikalen Schenkel der U- oder C-förmigen Querholme ausgebildet ist und Löcher für die Schraubverbindung mit den Vertikalholmen des rechten und linken Doppel-T-Rahmens aufweist.

Die Befestigungsplatten der Querholme sind zur Erhöhung der Stabilität und Tragfunktion mit Befestigungswangen versehen, welche rechtwinklig abgekantet sind und Endbereiche der vertikalen Schenkel und eines jeweils horizontalen Randsteges der Querholme umfassen bzw. an diesen anliegen.

Die erfindungsgemäße Rahmenkonstruktion ist vorteilhaft für unterschiedlich breite Rahmengestelle bzw. Verkabelungsschränke einsetzbar, wobei in einer außerordentlich einfachen Weise lediglich die Querholme längenmäßig angepasst werden müssen. Die seitlichen Doppel-T-Rahmen können unverändert übernommen werden.

Es liegt im Rahmen der Erfindung, durch eine einfache Änderung der Ausnehmung in den Tiefenholmen die Vertikalholme außermittig zur Ausbildung von unterschiedlichen front- und rückseitigen Rahmenausnehmungen anzuordnen und zu verbinden.

Die Erfindung wird nachstehend anhand einer Zeichnung weiter erläutert. In dieser zeigen in einer stark schematisierten Darstellung:
- Fig. 1: eine perspektivische Darstellung eines erfindungsgemäßen Rahmengestells;
- Fig. 2: eine vergrößerte Darstellung des fußseitigen Bereichs des erfindungsgemäßen Rahmengestells nach Fig. 1;
- Fig. 3: eine perspektivische Darstellung eines Tiefenholms des erfindungsgemäßen Rahmengestells;
- Fig. 4: eine perspektivische Darstellung eines oberen Bereichs eines Vertikalholms des erfindungsgemäßen Rahmengestells;
- Fig. 5: einen Querschnitt des Vertikalholms nach Fig. 4 und
- Fig. 6: eine perspektivische Darstellung eines Querholms.

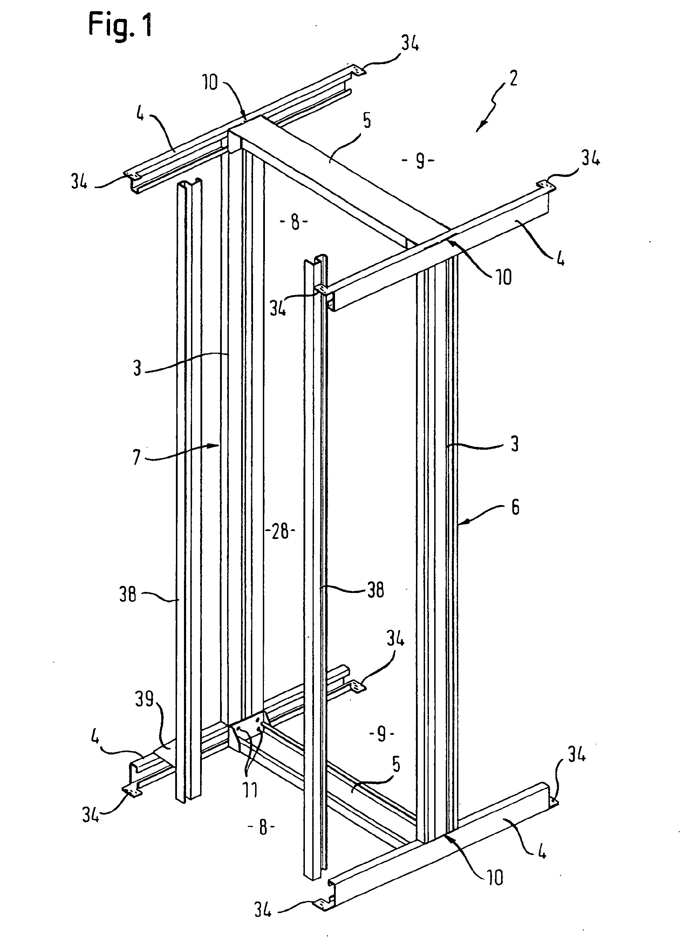

Fig. 1 zeigt ein Rahmengestell 2, welches eine hohe Stabilität und eine ungehinderte Verkabelung und Kabelführung in jede Richtung und damit eine vorteilhafte Verwendung für Netzwerkschränke und Schrankreihen mit hohen Verkabelungsdichten gewährleistet.

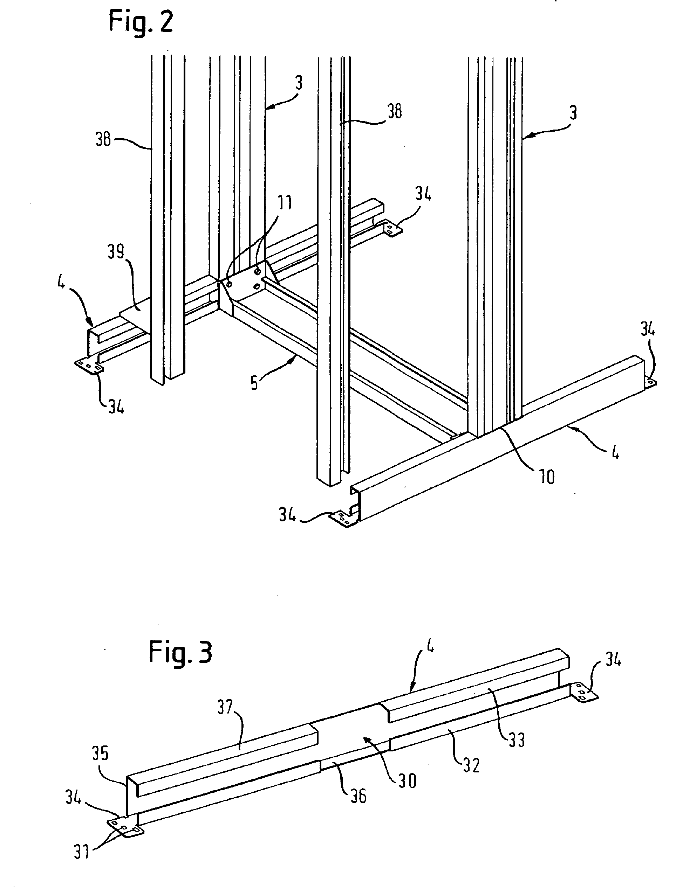

Das Rahmengestell 2 umfasst zwei Vertikalholme 3, vier Tiefenholme 4 und zwei Querholme 5, welche derart angeordnet und miteinander verbunden sind, dass eine frontseitige Rahmenausnehmung 8 und eine rückseitige Rahmenausnehmung 9 gebildet wird. Fig. 1 und auch die vergrößerte Teildarstellung der Fig. 2 verdeutlichen, dass eine Kabelführung ohne nachteilige Einfädelung möglich ist, da sowohl die im Allgemeinen üblichen front- und rückseitigen Vertikalholme als auch die front- und rückseitigen oberen und unteren Querholme entfallen.

Eine hohe Stabilität und gleichzeitig vorteilhafte Zugänglichkeit und Verkabelung werden erreicht durch die Verbindung jeweils eines Vertikalholms 3 mit einem am oberen und unteren Ende befestigten Tiefenholm 4, welche einen Doppel-T-Rahmen bilden. Die Verbindung der Tiefenholme 4 mit Endbereichen der Vertikalholme 3 erfolgt bevorzugt durch Schweißverbindungen 10 der in Ausnehmungen 30 der Tiefenholme 4 eingesetzten Vertikalholme 3 (siehe auch Fig. 3).

Der rechte 6 und linke Doppel-T-Rahmen 7 werden durch einen oberen und unteren Querholm 5 miteinander verbunden, wobei eine vorteilhafte, lösbare Schraubverbindung 11 zwischen den Querholmen 5 und den Tiefenholmen 4 des rechten Doppel-T-Rahmens 6 und des linken Doppel-T-Rahmens 7 vorgesehen ist.

Fig. 1 und Fig. 2 zeigen die spiegelbildliche Anordnung des rechten und linken Vertikalholms 3, der oberen und unteren Tiefenholme 4 und des oberen und unteren Querholms 5, welche einen Aufnahmeraum 28 für elektrische, elektronische und auch optoelektronische Geräte und Kabelführungen (nicht dargestellt) begrenzen.

Die Tiefenholme 4 sind jeweils endseitig mit Anbindungspunkten 34 für die Befestigung von Verkleidungsteilen, beispielsweise einer Rückwand, zweier Seitenwände, einer Abdeckung und eines Bodenblechs (nicht dargestellt) sowie für eine Scharnierung und Verschlusseinrichtung einer Tür (nicht dargestellt) versehen.

Die Tiefenholme 4 sind außerdem zur Befestigung von Montageholmen 38 ausgebildet, wobei diese Befestigung direkt oder indirekt über Adapter 39 und vorteilhafterweise in der Tiefe verstellbar durchgeführt werden kann.

Fig. 2 zeigt einen fußseitigen Bereich des Rahmengestells 2 gemäß Fig. 1. Gleiche Merkmale sind mit identischen Bezugszeichen versehen. Die vergrößerte Teildarstellung der Fig. 2 zeigt weitere Einzelheiten und insbesondere die Profilquerschnitte der Vertikalholme 3, Tiefenholme 4 und Querholme 5 und die Verbindungsbereiche 10, 11.

In Fig. 3 ist der linke untere Tiefenholm 4 gemäß Fig. 1 und 2 dargestellt. Der Tiefenholm 4 weist einen C-förmigen Querschnitt auf, welcher von einem außenseitig angeordneten vertikalen C-Schenkel 35, rechtwinklig zu diesem abgebogenen Horizontalschenkeln 36, 37 und rechtwinklig abgebogenen Innenschenkeln 32, 33 gebildet wird.

Eine Ausnehmung 30 zur Aufnahme eines Endbereichs eines Vertikalholms 3 (siehe Fig. 1 und 2) ist in diesem Ausführungsbeispiel mittig ausgebildet, indem der innenseitige Horizontalschenkel 37 und der abgebogene Innenschenkel 33 sowie der am außenseitigen Horizontalschenkel 36 abgekantete, unten angeordnete Innenschenkel 32 nicht durchgehend ausgebildet sind. Die Ausnehmung 30 ist komplementär zu den Endbereichen der Tiefenholme 4 dimensioniert und gewährleistet eine formschlüssige Aufnahme und ein Verschweißen des an dem vertikalen C-Schenkel 35 und dem außenseitigen Horizontalschenkel 36 flächig anliegenden und an den Horizontalschenkel 37 und beide Innenschenkel 32, 33 angrenzenden Vertikalholms 3.

Aus Fig. 3 geht hervor, dass die Anbindungspunkte 34 als nach innen gerichtete Winkel mit unterschiedlichen Öffnungen 31 ausgebildet sein können.

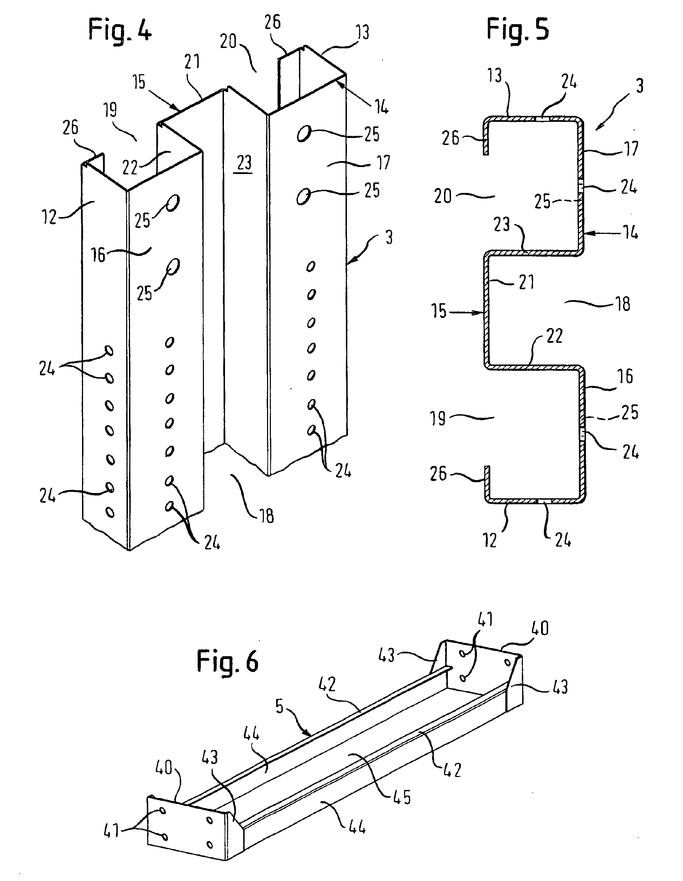

Fig. 4 zeigt einen oberen Bereich des linken Vertikalholms 3 gemäß Fig. 1, und in Fig. 5 ist ein Querschnitt dieses Vertikalholms 3 gezeigt. Beide Figuren 4 und 5 verdeutlichen die Ausbildung der Vertikalholme 3 als offene Dreikammerprofile, welche durch Mehrfachabkantungen bzw. -abbiegungen eines Zuschnitts hergestellt werden können.

Im Querschnitt weisen die Vertikalholme 3 eine rechteckige Kontur mit einer frontseitigen und rückseitigen Kurzseite 12, 13 und einer inneren und äußeren Längsseite 14, 15 auf. Die innere Längsseite 14 umfasst einen frontseitigen Innenschenkel 16 und einen rückseitigen Innenschenkel 17, zwischen denen eine Mittenöffnung 18 aufgrund von abgebogenen Querschenkeln 22, 23 und einem außenseitigen Verbindungsschenkel 21 gebildet ist. Durch die Mittenöffnung 18 können vorteilhaft Kabel eingeführt und verlegt werden. Eine Kabelführung ist auch im Bereich der äußeren Längsseite 15 möglich, welche aufgrund von etwa rechtwinkligen Abkantungen eine frontseitige Öffnung 19 und eine rückseitige Öffnung 20 aufweist. In diese frontseitige und rückseitige Öffnung 19, 20 ragen Kurzschenkel 26, welche als rechtwinklige Abkantungen der frontseitigen Kurzseite 12 und der rückseitigen Kurzseite 13 ausgebildet sind.

Befestigungsöffnungen 24 sind sowohl in den Kurzseiten 12, 13 als auch in dem frontseitigen und rückseitigen Innenschenkel 16, 17 ausgebildet. Außerdem sind Befestigungslöcher 25 für die Schraubverbindungen 11 (Fig. 1 und 2) vorgesehen, welche der Verbindung des rechten Doppel-T-Rahmens 6 und des linken Doppel-T-Rahmens 7 mit dem oberen und unteren Querholm 5 dienen.

Fig. 6 zeigt, dass die Befestigungslöcher 25 komplementär zu Löchern 41 in stirnseitig angeordneten Befestigungsplatten 40 der Querholme 5 ausgebildet sind. In diesem Ausführungsbeispiel sind vier Löcher 41 im Querholm 5 bzw. in den Befestigungsplatten 40 und entsprechend vier Befestigungslöcher 25 im Vertikalschenkel 3 bzw. in den beiden Innenschenkeln 16, 17 ausgebildet.

Der Querholm gemäß Fig. 6 ist nach oben bzw. unten offen und im Querschnitt U- bzw. C-förmig ausgebildet und weist beidseitig eines horizontal angeordneten Schenkels 45 vertikale Schenkel 44 und abgekantete horizontale Randstege 42 auf, welche nach innen gerichtet sind und endseitig von Befestigungswangen 43 umfasst werden. Die Befestigungswangen 43 sind als abgeschrägte 90° Abkantungen der Befestigungsplatten 40 ausgebildet, welche zur Erhöhung der Trag- und Stützfunktion beitragen.

## Patentansprüche

1. Rahmengestell
für Schränke, insbesondere für Netzwerkschränke und Schrankreihen mit hohen Verkabelungsdichten,
mit einem rechten und einem linken Vertikalholm (3), zwei oberen und unteren Tiefenholmen (4) und mit einem oberen und unteren Querholmen (5),
**dadurch gekennzeichnet,**
**dass** der rechte und der linke Vertikalholm (3) jeweils endseitig mit einem oberen und unteren Tiefenholm (4) zu einem rechten (6) und linken Doppel-T-Rahmen (7) verbunden ist und
**dass** der rechte (6) und linke Doppel-T-Rahmen (7) im Verbindungsbereich der Vertikalholme (3) und Tiefenholme (4) unter Ausbildung einer frontseitigen (8) und rückseitigen Rahmenausnehmung (9) durch den oberen und unteren Querholm (5) verbunden ist.

2. Rahmengestell nach Anspruch 1,
**dadurch gekennzeichnet,**
**dass** die Vertikalholme (3) mittels Schweißverbindungen (10) mit den oberen und unteren Tiefenholmen (4) zu dem rechten (6) und linken Doppel-T-Rahmen (7) verbunden sind.

3. Rahmengestell nach Anspruch 1 oder 2,
**dadurch gekennzeichnet,**
**dass** der rechte (6) und linke Doppel-T-Rahmen (7) lösbar mit dem oberen und unteren Querholm (5) verbunden ist.

4. Rahmengestell nach einem der vorhergehenden Ansprüche,
**dadurch gekennzeichnet,**
**dass** der rechte (6) und linke Doppel-T-Rahmen (7) durch Schraubverbindungen (11) mit dem oberen und unteren Querholm (5) verbunden ist.

5. Rahmengestell nach einem der vorhergehenden Ansprüche,
**dadurch gekennzeichnet,**
**dass** die Vertikalholme (3) als Mittelholme angeordnet sind.

6. Rahmengestell nach einem der vorhergehenden Ansprüche,
**dadurch gekennzeichnet,**
**dass** die Vertikalholme (3) offene Mehrkammerprofile und durch Mehrfachabkantungen oder -abbiegungen gebildet sind und eine rechteckige Kontur mit schmalen Kurzseiten (12, 13) aufweisen.

7. Rahmengestell nach einem der vorhergehenden Ansprüche,
**dadurch gekennzeichnet,**
**dass** die Vertikalprofile (3) eine innere Längsseite (14) mit einem frontseitigen (16) und einem rückseitigen Innenschenkel (17) sowie einer Mittenöffnung (18) und einer parallelen äußeren Längsseite (15) mit einer frontseitigen (19) und rückseitigen Öffnung (20) sowie einem Verbindungsschenkel (21) aufweisen, welche mittels Querschenkeln (22, 23) mit dem frontseitigen (16) und rückseitigen Innenschenkel (17) der äußeren Längsseite (15) verbunden sind.

8. Rahmengestell nach Anspruch 7,
**dadurch gekennzeichnet,**
**dass** für die Schraubverbindungen (11) zwischen dem rechten (6) und dem linken Doppel-T-Rahmen (7) und dem oberen und unteren Querholm (5) Befestigungslöcher (25) in dem frontseitigen (16) und rückseitigen Innenschenkel (17) der Vertikalholme (3) ausgebildet sind.

9. Rahmengestell nach Anspruch 7 oder 8,
**dadurch gekennzeichnet,**
**dass** der frontseitige Innenschenkel (16) und/oder rückseitige Innenschenkel (17) und/oder die frontseitige Kurzseite (12) und/oder rückseitige Kurzseite (13) Befestigungsöffnungen (24) für Schrank- und KabelmanagementKomponenten aufweist.

10. Rahmengestell nach einem der Ansprüche 7 bis 9,
**dadurch gekennzeichnet,**
**dass** die Vertikalprofile (3) zur Kabelführung ausgebildet sind und die Kabel über die Mittenöffnung (18) und/oder frontseitige Öffnung (19) und/oder rückseitige Öffnung (20) einführbar sind.

11. Rahmengestell nach einem der vorhergehenden Ansprüche,
**dadurch gekennzeichnet,**
**dass** die Vertikalprofile (3) im Bereich der äußeren Längsseite (15) Kurzschenkel (26) aufweisen, welche jeweils als rechtwinklige Abkantungen der frontseitigen (12) und rückseitigen Kurzseite (13) ausgebildet sind.

12. Rahmengestell nach einem der vorhergehenden Ansprüche,
**dadurch gekennzeichnet,**
**dass** die Tiefenholme (4) im Querschnitt C-förmig ausgebildet sind.

13. Rahmengestell nach einem der vorhergehenden Ansprüche,
**dadurch gekennzeichnet,**
**dass** die Tiefenholme (4) zur endseitigen Aufnahme der Vertikalholme (3) jeweils eine Ausnehmung (30) aufweisen.

14. Rahmengestell nach Anspruch 13,
**dadurch gekennzeichnet,**
**dass** die Ausnehmung (30) in einem innenseitig angeordneten Horizontalschenkel (37)und einem oberen (33) und einem unteren Innenschenkel (32) der Tiefenholme (4) ausgebildet ist.

15. Rahmengestell nach einem der vorhergehenden Ansprüche,
**dadurch gekennzeichnet,**
**dass** die Tiefenholme (4) Anbindungspunkte (34) für Verkleidungsteile, für eine Scharnierung und Verschlusseinrichtung einer Tür und/oder Befestigungspunkte für eine Rückwand, Abdeckung und/oder Seitenwände aufweisen.

16. Rahmengestell nach einem der vorhergehenden Ansprüche,
**dadurch gekennzeichnet,**
**dass** die Tiefenholme (4) zur tiefenverstellbaren Befestigung von metrischen oder 19"-Montageholmen (38) ausgebildet sind.

17. Rahmengestell nach einem der vorhergehenden Ansprüche,
**dadurch gekennzeichnet,**
**dass** die Querholme (5) als U- oder C-förmige Träger mit stirnseitigen Befestigungsplatten (40) ausgebildet sind.

18. Rahmengestell nach Anspruch 17,
**dadurch gekennzeichnet,**
**dass** die Befestigungsplatten (40) Löcher (41) für eine Schraubverbindung (11) mit dem rechten (6) und linken Doppel-T-Rahmen (7) aufweisen.

19. Rahmengestell nach Anspruch 17 oder 18,
**dadurch gekennzeichnet,**
**dass** die Querholme (5) horizontale Randstege (42) aufweisen, welche bis zu den Befestigungsplatten (40) reichen und von Befestigungswangen (43) an beiden Seiten der Befestigungsplatten (40) endseitig begrenzt sind.

20. Rahmengestell nach einem der vorhergehenden Ansprüche,
**dadurch gekennzeichnet,**
**dass** die Breite des Rahmengestells (2) durch unterschiedlich dimensionierte Querholme (5) variierbar ist.

## Claims

1. Frame structure
for cabinets, in particular for network cabinets and cabinet rows with high cabling densities,
having a right and a left-hand vertical member (3), two upper and lower depth members (4) and with an upper and a lower transverse member (5),
**characterized in that**
the right-hand and the left-hand vertical member (3) is in each case terminally connected to an upper and lower depth member (4) to form a right (6) and a left-hand double-T frame (7) and
that in the connecting area of the vertical members (3) and the depth members (4) the right (6) and left-hand double-T frame (7) are connected by the upper and lower transverse member (5), accompanied by the formation of a front (8) and a rear frame recess (9).

2. Frame structure according to claim 1,
**characterized in that**
the vertical members (3) are connected by welded joints (10) to the upper and lower depth members (4) to form a right (6) and left-hand double-T frame (7).

3. Frame structure according to claim 1 or 2,
**characterized in that**
the right (6) and left-hand double-T frame (7) is releasably connected to the upper and lower transverse member (5).

4. Frame structure according to one of the preceding claims,
**characterized in that**
the right (6) and left-hand double-T frame (7) is connected by screwed connections (11) to the upper and lower transverse member (5).

5. Frame structure according to one of the preceding claims,
**characterized in that**
the vertical members (3) are positioned as central members.

6. Frame structure according to one of the preceding claims,
**characterized in that**
the vertical members (3) are open multichamber sections and are formed by multiple bends and have a rectangle contour with narrow short sides. (12, 13).

7. Frame structure according to one of the preceding claims,
**characterized in that**
the vertical members (3) have an inner longitudinal side (14) with a front (16) and a rear inner leg (17), as well as a central opening (18) and a parallel, outer longitudinal side (15) with a front (19) and a rear opening (20), as well as a connecting leg (21), connected by transverse legs (22, 23) to the front (16) and rear inner leg (17) of the outer longitudinal side (15).

8. Frame structure according to claim 7,
**characterized in that,**
fixing holes (25) are formed in the front (16) and rear inner leg (17) of the vertical members (3) for the screwed connections (11) between the right (6) and the left-hand double-T frame (7) and the upper and lower transverse member (5).

9. Frame structure according to claim 7 or 8,
**characterized in that**
the front inner leg (16) and/or the rear inner leg (17) and/or the front short side (12) and/or the rear short side (13) have fixing openings (24) for cabinet and cable management components.

10. Frame structure according to one of the claims 7 to 9,
**characterized in that**
the vertical members (3) are constructed for cable routing and the cables can be introduced via the central opening (18) and/or the front opening (19) and/or rear opening (20).

11. Frame structure according to one of the preceding claims,
**characterized in that**
in the vicinity of an outer longitudinal side (15), the vertical members (3) have short legs (26), which are in each case constructed as right-angled bends from the front (12) and rear short side (13).

12. Frame structure according to one of the preceding claims,
**characterized in that**
the depth members (4) are C-shaped in cross-section.

13. Frame structure according to one of the preceding claims,
**characterized in that,**
for the terminal reception of vertical members (3), the depth members (4) have in each case a recess (30).

14. Frame structure according to one of the preceding claims,
**characterized in that**
the recess (30) is formed in an inside horizontal leg (37) and an upper (33) and a lower inner leg (32) of the depth members (4).

15. Frame structure according to one of the preceding claims,
**characterized in that**
the depth members (4) have connection points (34) for the covering parts, for a hinging and a locking device for a door and/or have fixing points for a rear wall, a cover and/or side walls.

16. Frame structure according to one of the preceding claims,
**characterized in that**
the depth members (4) are constructed for the depth-adjustable fixing of metric or 19" assembly members (38).

17. Frame structure according to one of the preceding claims,
**characterized in that**
the transverse members (5) are constructed as U- or C-shaped supports with front fixing plates (40).

18. Frame structure according to claim 17,
**characterized in that**
the fixing plates (40) have holes (41) for a screwed connection (11) to the right (6) and left-hand double-T frame (7).

19. Frame structure according to claim 17 or 18,
**characterized in that**
the transverse members (5) have horizontal marginal webs (42) which extend up to the fixing plates (40) and are terminally bounded by fixing side plates (43) on both sides of the fixing plates (40).

20. Frame structure according to one of the preceding claims,
**characterized in that**
the width of the frame structure (2) can be varied through differently dimensioned transverse members (5).

## Revendications

1. Armature pour armoire, notamment pour une armoire de réseau et une rangée d'armoires à forte densité de câblage, comprenant
un montant vertical (3) droit et gauche, deux longerons de profondeur (4) en haut et en bas ainsi qu'une traverse (5) supérieure et inférieure,
**caractérisée en ce que**
le montant vertical (3) droit et gauche (3) sont respectivement reliés en extrémité à un longeron de profondeur (4) haut et bas pour former un cadre droit en double T (6) et un cadre gauche en double T (7) et
les cadres droit (6) et gauche (7) en forme de double T sont reliés dans la zone de liaison des montants verticaux (3) et des longerons de profondeur (4) par la traverse supérieure et la traverse inférieure (5) pour former une cavité de cadre avant (8) et une cavité de cadre arrière (9).

2. Armature selon la revendication 1,
**caractérisée en ce que**
les montants verticaux (3) sont reliés par des liaisons soudées (10) aux longerons de profondeur supérieur et inférieur (4) du cadre droit (6) et du cadre gauche (7) en forme de double T.

3. Armature selon la revendication 1 ou 2,
**caractérisée en ce que**
les cadres droit (6) et gauche (7) en forme de double T sont reliés de manière amovible à la traverse supérieure et à la traverse inférieure (5).

4. Armature selon l'une des revendications précédentes,
**caractérisée en ce que**
les cadres droit (6) et gauche (7) en forme de double T sont reliés à la traverse supérieure et à la traverse inférieure (5) par des liaisons vissées (11).

5. Armature selon l'une des revendications précédentes,
**caractérisée en ce que**
les montants verticaux (3) sont installés comme montants médians.

6. Armature selon l'une des revendications précédentes,
**caractérisée en ce que**
les montants verticaux (3) sont des profilés ouverts à plusieurs chambres, pliés ou cintrés plusieurs fois et ils ont un contour rectangulaire avec des petits côtés courts (12, 13).

7. Armature selon l'une des revendications précédentes,
**caractérisée en ce que**
les montants verticaux (3) ont un côté longitudinal intérieur (14) avec une branche intérieure avant (16) et une branche intérieure arrière (17) ainsi qu'une ouverture centrale (18) et un côté longitudinal extérieur (15), parallèle, avec une ouverture avant (19) et une ouverture arrière (20) ainsi qu'une branche de liaison (21) reliée par des branches transversales (22, 23) à la branche intérieure avant (16) et à la branche intérieure arrière (17) du côté longitudinal (15).

8. Armature selon la revendication 7,
**caractérisée en ce que**
pour les raccords vissés (11) entre les cadres droit (6) et gauche (7) en double T et les traverses (5) supérieure et inférieure des orifices de fixation (25) sont prévus dans la branche intérieure avant (16) et dans la branche intérieure arrière (17) des montants verticaux (3).

9. Armature selon l'une des revendications 7 ou 8,
**caractérisée en ce que**
la branche intérieure avant (16) et/ou la branche intérieure arrière (17) et/ou le côté court avant (12) et/ou le côté court arrière (13) comportent des orifices de fixation (24) pour les composants d'une armoire et pour les composants de gestion de câbles.

10. Armature selon l'une des revendications 7 à 9,
**caractérisée en ce que**
les profils verticaux (3) sont réalisés comme guides-câbles et les câbles passent par l'ouverture centrale (18) et/ou l'ouverture côté avant (19) et/ou l'ouverture arrière (20).

11. Armature selon l'une des revendications précédentes,
**caractérisée en ce que**
les profils verticaux (3) ont des branches courtes (26) dans la zone des grands côtés extérieurs (15), ces branches courtes étant réalisées chacune comme bord replié à l'équerre du côté court avant (12) et du côté court arrière (13).

12. Armature selon l'une des revendications précédentes,
**caractérisée en ce que**
les longerons de profondeur (4) ont une section en forme de C.

13. Armature selon l'une des revendications précédentes,
**caractérisée en ce que**
les longerons de profondeurs (4) comportent respectivement une cavité (30) pour recevoir l'extrémité du montant vertical (3).

14. Armature selon la revendication 13,
**caractérisée en ce que**
la cavité (30) est réalisée dans une branche horizontale (37) située du côté intérieur et dans une branche intérieure supérieure (33) ainsi que dans une branche intérieure inférieure (32) des longerons de profondeur (4).

15. Armature selon l'une des revendications précédentes,
**caractérisée en ce que**
les longerons de profondeur (4) comportent des points de liaison (34) pour des pièces d'habillage, pour des charnières et des installations de fermeture d'une porte et/ou des points de fixation pour une paroi arrière, un dessus et/ou des parois latérales.

16. Armature selon l'une des revendications précédentes,
**caractérisée en ce que**
les longerons de profondeur (4) sont réalisés pour être fixés de manière réglable en profondeur par des longerons de montage (38) métriques ou de type 19".

17. Armature selon l'une des revendications précédentes,
**caractérisée en ce que**
les traverses (5) sont des poutrelles en U ou en C avec des plaques de fixation (40) dans leurs côtés frontaux.

18. Armature selon la revendication 17,
**caractérisée en ce que**
les plaques de fixation (40) comportent des orifices (41) pour une liaison vissée (11) avec les cadres droit (6) et gauche (7) en forme de double T.

19. Armature selon les revendications 17 ou 18,
**caractérisée en ce que**
les traverses (5) ont des entretoises à bord horizontal (42) qui arrivent jusqu'aux plaques de fixation (40) et sont délimitées en extrémité par des parois de fixation (43) des deux côtés des plaques de fixation (40).

20. Armature selon l'une des revendications précédentes,
**caractérisée en ce que**
la largeur de l'armature (2) peut être modifiée par des traverses (5) de dimensions différentes.
